# EUROPEAN PATENT APPLICATION

(11) **EP 2 918 410 A1**
(43) Date of publication of application: **16.09.2015**
(21) Application number: 14158539.8
(22) Date of filing: 10.03.2014
(51) Int. Cl.: B41F 15/08, B41F 15/26, H01L 31/00, H05K 3/12

(54) **Rotary table and solar cell processing system**

(71) Applicant: APPLIED MATERIALS ITALIA S.R.L., 31048 San Biagio di Callalta (TV) (IT)
(72) Inventor: Gislon, Daniele, 30036 Santa Maria di Sala - Venice (IT)
(74) Representative: Zimmermann & Partner Patentanwälte mbB

(57) **Abstract**

A rotary table (130) for receiving at least one printing nest is provided. The rotary table is provided with inertia reduction areas (10, 145, 146) that may be one or more recesses provided in the outer circumference of the rotary table, at least one cut-out in the rotary table, and/or at least one area with a reduced thickness. A solar cell processing system (110) is provided that includes at least one rotary table as described herein.

## Description

### FIELD OF THE INVENTION

Embodiments of the present disclosure relate to a rotary table as used in deposition systems for printing electrodes on solar cell wafers, in particular in screen deposition systems for printing electrodes on solar cell wafers. In particular, embodiments of the present disclosure relate to a rotary table configured to rotate and thereby transport solar cell wafers along an orbit as defined by the rotary table's rotational movement. Furthermore, the present disclosure relates to solar cell processing systems including the described rotary table.

### DESCRIPTION OF THE RELATED ART

Solar cell devices are photovoltaic (PV) devices that convert sunlight into electrical power. A typical solar cell device, which might also be called only "solar cell" or "cell" herein, includes a substrate that may also be called wafer herein. The wafer is typically made of silicon. The wafer may be provided with one or more p-n or p-i-n junctions formed therein. Each p-n junction has a p-type region and an n-type region. When the p-n junction is exposed to sunlight, the sunlight is converted to electricity through the PV effect. A multitude of solar cells are typically assembled together to form a panel or, synonymously, a module. Panels are installed, for instance, on house roofs or the like.

Solar cells are commonly formed from silicon substrates, which can be monocrystalline or multi-crystalline silicon substrates. The silicon substrate may have a thin layer of n-type silicon on the front side with a p-type zone formed on the backside. Alternatively, the silicon substrate may have a thin layer of p-type silicon on the front side with an n-type zone formed on the backside (so-called "n-type wafer"). Electrodes are deposited on the solar cell wafer that conduct the current generated by the incident light. Additional layers such as anti-reflection layers on the front side, or reflection layers on the backside may furthermore be provided.

Known solar cell production includes the use of conveyor belts that transport the unprocessed or partly processed wafers to the various processing stations, such as, cleaning, infusion, depositing (e.g., printing), or binning stations. It may be useful to include one or more rotary tables in the production process for various reasons.

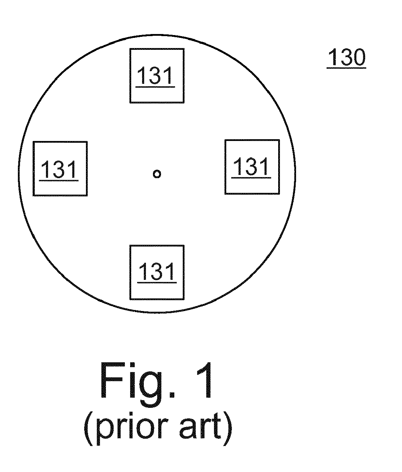

With reference to Fig. 1, a rotary table as known in the art is shown in a schematic top view. The rotary table 130 is configured to include four printing nests 131. Each printing nest 131 is configured to receive a solar cell wafer. The rotary table may be rotated in order to move the solar cell wafers positioned on the printing nests 131 according to a clockwise or anti-clockwise rotation. In order to do so, the rotary table has to accelerate to a maximum rotational speed and then to decelerate the movement again to halt the table again.

Solar cell production industries are subject to an enormous price pressure. For a solar cell production system, one of the essential characteristic numbers is the throughput as measured by the number of produced solar cells per hour. In order to maximize this number, each step during the solar cell production has to be optimized. In particular, given a certain quality, each process steps and each transportation step has to be minimized.

As found by the inventors of the present disclosure, it turns out that present solar cell production can still be optimized.

### SUMMARY OF THE INVENTION

In view of the above, the present disclosure provides the following.

According to an aspect of the present disclosure, a rotary table for receiving at least one solar cell printing nest is provided. The rotary table is provided with inertia reduction areas.

In particular, the rotary table may be provided with a non-circular circumference. Typically, one or more recesses may be provided in the outer circumference of the rotary table. Additionally or alternatively, the rotary table may be provided with at least one cut-out in the rotary table. Additionally or alternatively, areas with a reduced thickness may be provided.

According to a further aspect of the present disclosure, a solar cell processing system is provided. The solar cell processing system includes at least one rotary table as described herein.

In particular, the solar cell processing system as described herein may be provided with at least one printing station for printing electrodes on the solar cell wafers.

Further embodiments, aspects, details and advantages are furthermore evident from the dependent claims, the description, and the drawings.

### BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the disclosure and are described in the following:
Fig. 1 illustrates a schematic view of rotary table as known in the art.
Fig. 2 illustrates a schematic perspective view of a solar cell processing system according to embodiments described herein.
Fig. 3 illustrates a schematic top view of a solar cell processing system according to embodiments described herein.
Figs. 4 to 8 show schematic views of embodiments of the rotary table according to the present disclosure provided with recesses positioned in the circumference of the rotary table.
Fig. 9 shows a schematic view of an embodiment of the rotary table including several cut-outs according to the present disclosure
Figs. 10-11 show schematic views of embodiments of the rotary table according to the present disclosure provided with recesses positioned in the circumference of the rotary table and with cut-outs in the rotary table.
Fig. 12 shows a schematic cross-sectional view of a rotary table according to embodiments described herein.

### DETAILED DESCRIPTION OF EMBODIMENTS

Reference will now be made in detail to the various embodiments of the invention, one or more examples of which are illustrated in the figures. Within the following description of the drawings, the same reference numbers refer to same components. In the present disclosure, only the differences with respect to individual embodiments are described. Each example is provided by way of explanation of the invention and is not meant as a limitation of the invention. Further, features illustrated or described as part of one embodiment can be used on or in conjunction with other embodiments to yield yet a further embodiment. It is intended that the description includes such modifications and variations.

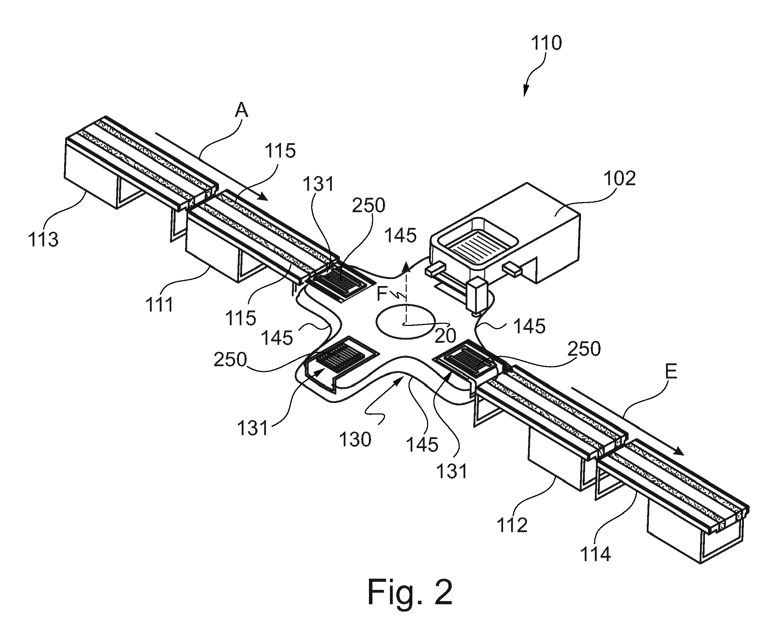

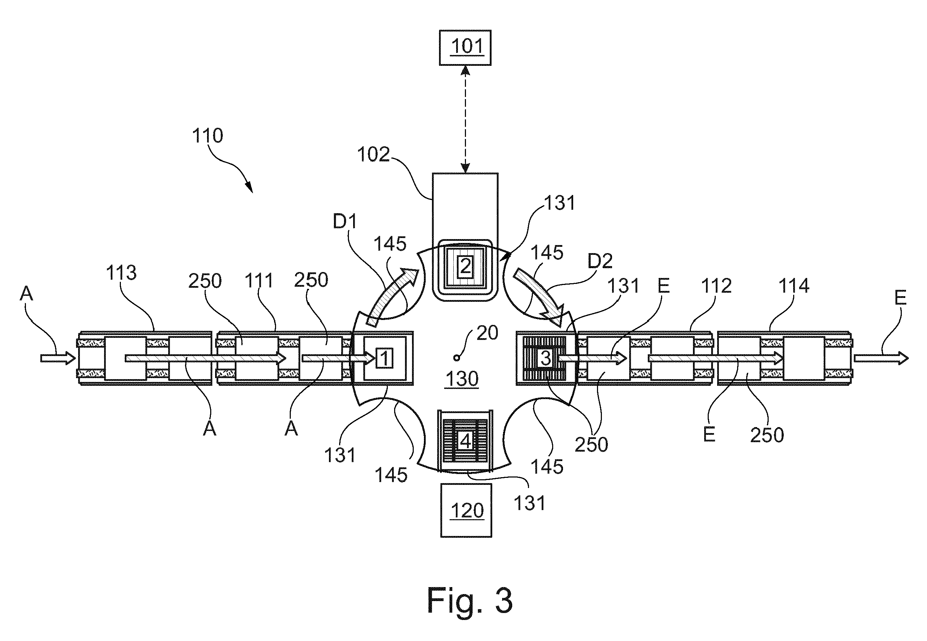

With reference to Fig. 2, a deposition system is exemplarily shown. As illustrated, the deposition system 110 may comprise an incoming conveyor 111. In other embodiments not shown in the figures, a second incoming conveyor may be provided that is typically parallel to the first incoming conveyor. The incoming conveyor typically includes one or more conveyor belts. For instance, as illustrated, the conveyor may include two conveyor belts 115 arranged in parallel, for example, at a distance to each other of between 5 cm and 15 cm. The incoming conveyor 111 may be configured to receive a solar cell wafer 250 from an input device, such as an input conveyor 113 (i.e., path "A" in Figs. 2 and 3), and transfer the solar cell wafer 250 to a solar cell printing nest 131 (also called only "printing nest") disposed on the rotary table 130.

As used herein, the term "substrate" or "solar cell wafer" may refer to a semiconductor substrate that is processed to become a solar cell. Various process steps may be applied to produce the solar cell, in particular, printing fine lines of conductive material allowing a current to flow therethrough. Such a printing step is typically performed in a screen print chamber 102. Typical sizes of a solar cell wafer are between 10 cm and 20 cm.

The deposition system as exemplarily illustrated in Fig. 2 further includes a rotary table 130, the screen print chamber 102, and an outgoing conveyor 112. Instead of the shown screen print chamber 102 other deposition systems may be employed that allow the deposition of conductive electrodes on the solar cell wafer. In particular, printing may also be accomplished with a stencil (e.g., a stencil printing chamber).

The screen print chamber 102 typically extends over the rotary table 130. Printing is done while the solar cell wafer rests on the printing nest 131 of the rotary table 130.

A solar cell printing nest 131, or also called only "printing nest" herein, may consist of a conveyor assembly which has a feed spool, a take-up spool, rollers and one or more actuators, which are coupled to or adapted to temporarily engage with the feed spool and/or the take-up spool. The spools are adapted to feed and retain a supporting material. In embodiments, the supporting material is a porous material that allows the solar cell wafer, which is disposed on the supporting material, to be retained to the printing nest by underpressure from below the supporting material. In one embodiment, the supporting material is a transpirable material, such as transpirable paper. In embodiments, the feed spool and the take-up spool are each adapted to receive opposing ends of the supporting material.

Furthermore, solar cell wafer inspection may be performed at one or more of the positions "1", "2", "3" or "4" as illustrated in Figs. 2 and 3. In particular, solar cell wafer inspection may take place before printing the solar cell wafer (which is done at position "2" according to the embodiments of Figs. 2 and 3) and/or after printing the solar cell wafer. For instance, one or more cameras (not shown) may be provided above the rotary table.

The outgoing conveyor 112 may be configured to receive a processed solar cell wafer 250 from a printing nest 131 on the rotary table 130 and to transfer the solar cell wafer 250 to an exit conveyor 114 (i.e., path "E" in Figs. 2 and 3). The input conveyor 113 and the exit conveyor 114 may be automated substrate handling devices that are part of a larger production line.

The rotary table 130 is adapted to be rotated about a center axis that is illustrated with "F" in Fig. 2. A rotary actuator (not shown) may be provided to drive the rotational movement.

A system controller 101 may be provided to control the rotary actuator. Typically, the rotary actuator is adapted to rotate the rotary table at 90°, 180°, or 270 ° in one motion. The control of the rotary actuator is typically such that one printing nest 131 is positioned within the deposition system 110 (e.g., paths "D1" and "D2" in Fig. 3).

In embodiments, the rotary table 130 may be configured to receive four printing nests 131, or substrate supports. The rotary table 130 may also include one or more, in particular four printing nests. Generally, and not limited to any embodiment, each printing nest is typically adapted to support a solar cell wafer 250 during the deposition process performed in the deposition system.

Fig. 3 is a schematic top view of the deposition system according to embodiments described herein. Fig. 3 schematically illustrates the position of the rotary table 130 in which one printing nest 131 is in position "1" to receive a solar cell wafer 250 from the incoming conveyor 111, another printing nest 131 is in position "2" in the screen print chamber 102 where a printed pattern is deposited on the upper surface of the solar cell wafer. Another printing nest 131 is in position "3" for transferring the processed substrate 250 to the one or more outgoing conveyor 112 and/or 114.

As shown in the exemplary embodiment of Fig. 3, another printing nest 131 is in position "4", which is an intermediate stage between position "1 " and position "3". It may be possible that a substrate is rotated up to position "4" in case it is damaged and cannot further be processed. In this case, the printing nest 131 on position "4" may allow discarding a solar cell wafer into a bin 120 for broken or otherwise damaged substrates.

In order to reduce the cycle time of the deposition system and to increase the number of printed solar cells per hour, the deposition process and/or the transportation time can be reduced. Embodiments of the present disclosure aim at reducing the transportation time. This means for the operation of the rotary table that the rotations thereof should be performed in the shortest possible time. In other words, the rotational movement of the rotary table has to be carried out at a high angular acceleration and a high top speed.

The control of the rotary actuator according to embodiments described herein may be such that the actuator accelerates to a maximum rotational speed and, for instance, without keeping this speed, decelerates again. Since deceleration is less power consuming to perform, according to embodiments, the control of the rotary actuator may be such that the time used for acceleration of the rotary table may be larger than the time necessary for deceleration.

For illustrative purposes, an example shall be given as follows. Assume a rotation of the rotatory table about 90°, for instance, to move an incoming solar cell wafer from position "1" in Fig. 3 to the printing chamber 102, i.e., to position "2" in Fig. 3. Starting at an angle of 0°, the rotary actuator accelerates the rotary table up to the 60° position of the rotary table. In other words, at the 60° position of the rotary table the maximum rotational speed of the rotary table is reached.

Once the 60° are reached, the rotary table may be decelerated again to come to a halt at the 90° position. Notably, although the deceleration could technically be further intensified, the control of the acceleration and deceleration still has to fulfill the requirement that the solar cell wafers positioned on the printing nests shall keep their position. In various embodiments described herein, in order to avoid any movement of the solar cell wafers in relation to the printing nests, an underpressure suction may be applied to the solar cell wafers from below in order to fix them temporarily to the printing nest.

In order to maximize the acceleration and to ease the deceleration, the inventors of the present disclosure propose using a rotary table with a reduced inertia as compared to prior art rotary tables. Various examples for those rotary tables are discussed in the following. The embodiments as discussed aim at a reduction of the inertia by providing regions of a reduced inertia. A realization thereof may be accomplished as follows.

Firstly, as discussed already with respect to the embodiments of Figs. 2 and 3, the rotary table may be provided with a non-circular circumferential shape such that the outer circumference of the rotary table is provided with recesses.

Secondly, the rotary table may be provided with cut-outs. A cut-out as understood herein distinguishes from a recess in that it is positioned in the rotary table. In other words, a cut-out as understood herein is embedded in the rotary table whereas a recess is positioned at the rotary table's outer circumference.

Thirdly, the rotary table may be provided with a thinning. Typically, a thinning as understood herein is a region of the rotary table that has reduced thickness as compared to adjacent regions. Whereas the area of a recess and the area of a cut-out do not contribute to any inertia of the rotary table, the area of a thinning still contributes to the inertia of the rotary table, although at a reduced amount.

Typically, the rotary table according to the present disclosure is rotationally symmetric with respect to the rotation axis.

As already illustrated in the deposition system embodiments of Figs. 2 and 3, the rotary table 130 shown therein has a non-circular circumference. In particular, the non-circular circumference is provided at the regions between the positions of the printing nests.

Notably, the adaption of a rotary table to receive a printing nest may already lead to a non-circular shape at the respective positions of the printing nests. This is not intended by the meaning of "non-circular circumference" as used in the present disclosure. The non-circular circumference as understood herein is generally provided at the regions between the positions of two adjacent printing nests. The non-circular circumference may be understood herein in that the circumference includes one or more recesses that define a deviation from the theoretic circular shape of the rotary table.

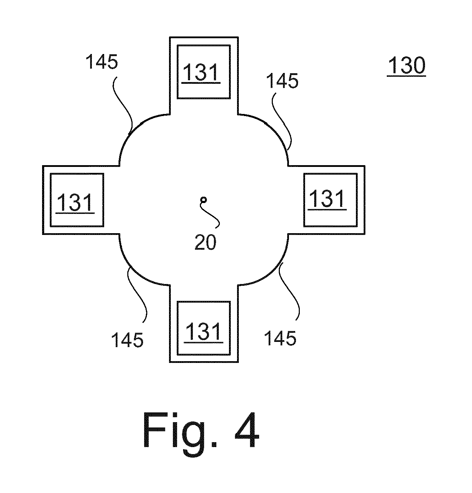

Figs. 2 and 3 illustrate one possible non-circular circumferential shape of a rotary table 130. It shall be understood that the deposition system 110 as illustrated in Figs. 2 and 3 may include other rotary table instead, in particular, a rotary table as described in more detail with respect to the Figs. 4 to 12.

In the embodiments illustrated in Figs. 2 and 3, between the positions of the printing nests 131, recesses 145 as compared to the theoretic circular circumference are provided. According to various embodiments described herein, and not limited to the embodiments shown in Figs. 2 and 3, the recesses are particularly provided at the outer circumference of the rotary table since the outer parts have a larger impact on the rotational inertia of the rotary table. For instance, as illustrated in Figs. 2 and 3, the recesses 134 provided in the rotary table according to embodiments described herein may have the shape of a semi-circle. This allows a high inertia reduction of the rotary table on the outer part.

Each additional mass of the rotary table leads to an additional inertia of the rotary table. In order to rotate the rotary table quickly, as discussed before, acceleration and deceleration forces need to be applied. This in turn may require strong rotary actuators and thus high costs of production and operation if the inertia is too large. On the other hand, if it is possible to reduce the inertia of the rotary table, the rotary actuators can be smaller and their current consumption can be reduced.

According to embodiments, the rotary table is provided with four recesses as compared to a theoretic circular circumference of the rotary table. In particular, one recess is provided between each two adjacent printing nest positions.

Figs. 4 to 8 show schematic drawings of embodiments wherein the inertia reduction areas are provided by recesses in the outer circumference of the rotary table, thus leading to a non-circular circumference of the rotary table.

As illustrated in Figs. 4, 5, and 6, the rotary table may have a cross-like shape. As shown in the embodiment of Fig. 4, the inner part of the rotary table may have a circular shape. This may have a positive effect on the stability. Furthermore, as discussed, the inner part of the rotary table contributes less to the rotationally relevant inertia as compared to the outer part of the rotary table. The outer part of the rotary table is provided with recesses 145 that extend over the region between the four printing nests 131. As this outer region is the region that is highly relevant for the rotational inertia, the shown embodiment provides essential acceleration benefits over a rotary table as known in the art.

As understood herein, the recesses may have a length of at least 10 cm or at least 30 cm in the radial direction of the rotary table. In embodiments, such as illustrated in Figs. 4, 5, and 6, the recesses may have a length in the radial direction of the rotary table of at least the length of the printing nest with respect to the radial direction of the rotary table.

The non-circular shape provided with recesses as illustrated, for instance, in Figs. 4, 5, and 6 may also be described in that the printing nests are provided on arms that extend from a central part of the rotary table. For certain embodiments, this is just another way of describing the situation that the rotary table is provided with circumferentially positioned recesses.

Each printing nest may be positioned on one arm. The arm may be designed and shaped in a manner sufficient for carrying the printing nests, in particular during the additional load of acceleration and deceleration of the rotary table. In any event, according to the present understanding, a rotary table is understood as the complete table which is rotated in operation of the solar cell processing system.

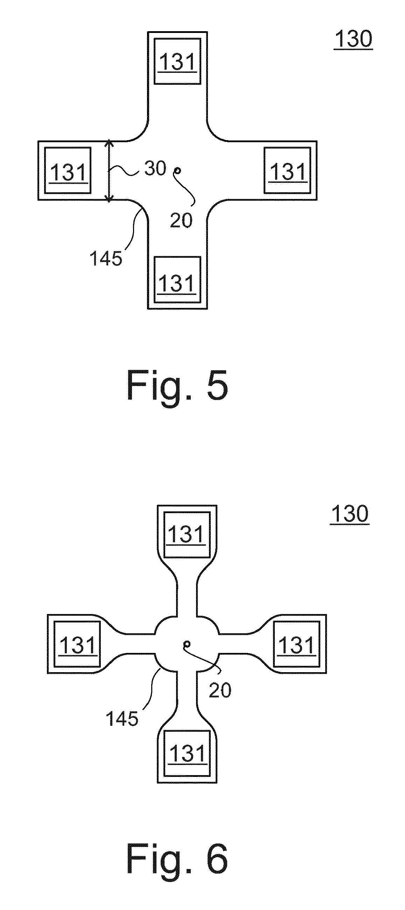

With reference to Fig. 5, a further embodiment of a rotary table is shown. Again, the shape of the rotary table is provided with a cross-like shape and adapted to receive four printing nests 131 located on the outer circumference of the rotary table. Each printing nest is connected to the central part of the rotary table by an arm defined by the recesses 145 which provided in the circumference of the rotary table. The recesses are sized and shaped such that the width 30 of the remaining rotary table in between the recesses (i.e., with respect to the tangential direction of the rotary table) substantially corresponds to the width of the printing nests (with respect to the tangential direction of the rotary table). The term "substantially" as understood in this context does typically not include a deviation of more than 20%.

As used herein, the wording "a recess is provided in the circumference of the rotary table" is typically understood in that the recess may extend over an essential length of the rotary table with respect to the radial direction of the rotary table. It may even be possible that such an "extension provided in the circumference of the rotary table" may reach close to the center of the rotary table, wherein "close to the center" may be understood as "with a maximum distance of 20 cm or even 10 cm to the center 20 of the rotary table". Evidently, the center of the rotary table is understood as the rotation axis of the rotary table.

Fig. 6 illustrates a further embodiment with a cross-like shaped rotary table. As in the embodiments illustrated with respect to Fig. 5, the recesses 145 are such that the printing nests are located on arms that all lead to the central part of the rotary table. The width of the arms may be generally constant along their radial extension, as it was illustrated with respect to Fig. 5. However, the width of the arms may also vary, in particular, they may increase along the radial direction with increasing distance to the center 20. This is due to the fact that the loads on parts of the arms which are positioned further away from the center of the rotary table are larger than the loads with which the inner parts of the arms are faced during rotational acceleration and deceleration. Such an increase of the arm width is illustrated in Fig. 6.

In particular the embodiment of Fig. 6 allows a high reduction of the rotationally relevant inertia as compared to the prior art embodiments.

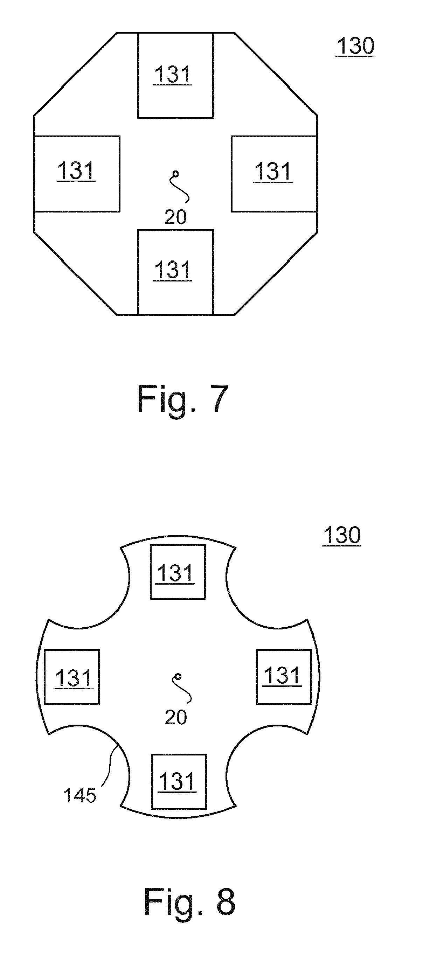

Fig. 7 illustrates a further embodiment. As illustrated therein, without limitation thereto, the rotary table may have a polygonal shape. In particular, the rotary table may have an octagonal shape, however, other shapes such as a quadratic shape (with the printing nest positions typically being at the corners of the rectangle) are also possible.

Fig. 8 illustrates a further embodiment of a rotary table. The rotary table 130 as shown is similar to the rotary table as illustrated in Figs. 2 and 3. The rotary table is provided with four recesses 145 each positioned between the respective positions of adjacent printing nest positions. As illustrated, the recesses may have the shape of semicircle with the center of the semicircle being located, for instance, at or close to the theoretical circular shape of the rotary table. In embodiments, the radius of the semicircle may be at least 20 cm.

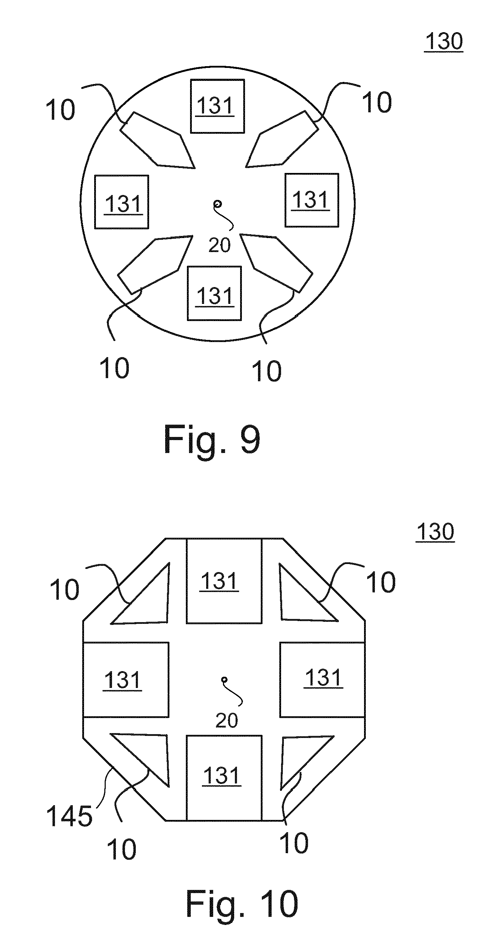

Fig. 9 illustrates a further embodiment of a rotary table as disclosed herein. Contrary to all the other rotary table embodiments, the rotary table illustrated in Fig. 9 has a circular circumference. The areas for reducing the inertia of the rotary table of Fig. 9 are accomplished by cut-outs 10 provided within the outer circumference of the rotary table 130.

Generally, and not limited to any embodiment described in the Figures, it is possible that a plurality of cut-outs are provided, for instance, four cut-outs or even more. In case that four cut-outs are provided, they are typically each positioned between two adjacent printing nests. The number of cut-outs is typically a multiple of the number of printing nests. For instance, in case of four printing nests, four, eight, twelve and so cut-outs may be provided. It is also possible that a high number of cut-outs are provided, such as fifty or more.

The shape of the cut-outs may be circular, elliptical, polygonal or the like. Circular cut-outs are beneficial for production reasons. The position of the cut-outs close to the outer circumference of the rotary table is beneficial in that the inertia relevant to the rotational acceleration and deceleration is reduced more than in case of cut-outs closer to the center of the rotary table.

For instance, according to embodiments, at least 50% of the surface of a theoretical circular rotary table may be replaced with one or more recesses and/or one or more cut-outs according to embodiments as described herein. In particular, at least 50% of the surface of the outer part of a theoretical circular rotary table is replaced with one or more recesses and/or one or more cut-outs according to embodiments as described herein. Herein, the outer part shall be understood as the region between half of the radius of the rotary table and the radius. The outer part thus constitutes 3/4 of the overall surface and mass of a circular rotary table (let r be the radius, then the surface of the outer part calculates as πr²-(π1/2r)²=3/4πr²). In addition, the outer part has to move over longer distances than the inner part in the same time, that is why the outer parts are highly relevant to the rotational inertia of the rotary table.

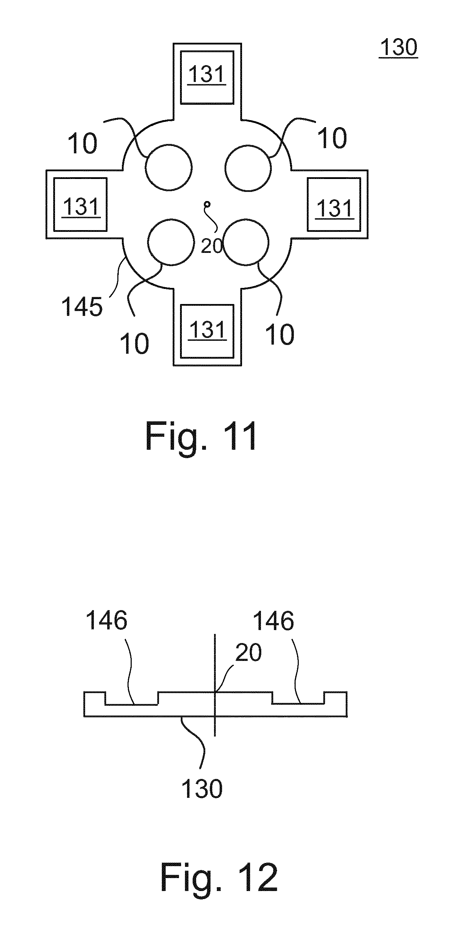

The embodiments of Figs. 10 and 11 illustrate rotary tables wherein the means for the reduction of the inertia include both recesses 145 provided at the outer circumference of the rotary table and cut-outs 10 embedded in the rotary table 130. As shown in Fig. 10 and 11, the recesses may be provided between the printing nests. As illustrated in Fig. 11, and not limited to any embodiment, the recesses may shape the outer part of the rotary table such that the printing nests are positioned on arms, and additionally cut-outs may be provided in the inner part of the rotary table. Additionally, although not shown, cut-outs on the arms could be provided.

In addition or alternatively to the recesses and/or cut-outs as described in the previous embodiments, the rotary table may also be provided with one or more areas having a reduced thickness of the rotary table. For instance, the thickness in one or more areas of the rotary table may be less than 70% or even less than 50% of the thickness of adjacent areas of the rotary table.

A typical maximum thickness of a rotary table as described herein is in the range of between 25 cm and 50 cm. A typical reduced thickness as described herein in in the range of below 25 cm.

Fig. 12 shows a schematic cross-section view of an embodiment of a rotary table 130 provided with areas 146 of a reduced thickness. For stability reasons, the areas of the reduced thickness may alternate with areas of the normal thickness of the rotary table. It is even possible that ribs or the like are provided on the rotary table that have an increased thickness. Increased thickness is understood as compared to the normal thickness. The normal thickness of the rotary table typically corresponds to the thickness at the center 20 or close to the center. The advantage of such a design under stability considerations may outbalance disadvantages in terms of additional weight and inertia.

The rotary table as proposed herein has a reduced mass as compared to rotary tables known in the art, and thus a reduced inertia as compared to prior art rotary tables. Consequently, the acceleration and deceleration of the rotary table can be improved as compared to prior art rotary tables.

Consequently, due to the reduced inertia of the rotary tables according to the embodiments described herein, with a given rotary actuator, the acceleration of the rotary table is increased and thus, under otherwise equal conditions, the solar cell wafers can be transported between their positions 1, 2, 3, or 4 in a shorter time. The overall throughput of the deposition system is thereby increased and the solar cell processing system has a higher production rate (i.e., more wafers per hour). Not limited to any embodiment, the moment of inertia relevant for the rotation is typically below 4*10⁶ kg*mm², such as 3715659 kg*mm². This is an essential reduction as compared to prior art rotary tables with values of more than 4*10⁶kg*mm².

While the foregoing is directed to embodiments of the invention, other and further embodiments of the invention may be devised without departing from the basic scope thereof, and the scope thereof is determined by the claims that follow.

## Claims

1. A rotary table (130) for receiving at least one solar cell printing nest, wherein the rotary table (130) is provided with inertia reduction areas (10, 145, 146).

2. The rotary table according to any of the preceding claims, wherein the inertia reduction areas include at least one recess (145) in the circumference of the rotary table.

3. The rotary table according to claim 2, wherein the provision of the at least one recess (145) leads to a non-circular circumference of the rotary table.

4. The rotary table according to claim 2 or 3, wherein the shape and size of the recesses (145) is such that the rotary table (130) has a polygonal shape, in particular an octagonal shape.

5. The rotary table according to any of the preceding claims, wherein the inertia reduction areas include cut-outs (10) in the rotary table.

6. The rotary table according to claim 5, wherein the cut-outs are positioned at a distance of more than half of the radius of the rotary table from the center (20) of the rotary table.

7. The rotary table according to claim 5 or 6, wherein the cut-outs have a circular, elliptical or polygonal shape.

8. The rotary table according to any of the preceding claims, wherein the inertia reduction areas include at least one area (146) with a reduced thickness of the rotary table.

9. The rotary table according to any of the preceding claims, wherein the rotary table is configured to receive four solar cell printing nests (131).

10. The rotary table according to any of the preceding claims, wherein the rotary table comprises at least one solar cell printing nest (131), optionally four solar cell printing nests.

11. The rotary table according to any of the preceding claims, wherein the rotary table (130) has a cross-like shape.

12. The rotary table according to any of the preceding claims, wherein the moment of inertia of the rotary table is below 4*10⁶ kg*mm².

13. A solar cell processing system (110) including a rotary table according to any of the preceding claims.

14. The solar cell processing system according to claim 13, further comprising a printing station (102).

15. The solar cell processing system according to any of claims 13 to 14, further including an incoming conveyor (111) and an outgoing conveyor (112).
